Europäisches Patentamt

European Patent Office

Office européen des brevets

(11) Veröffentlichungsnummer: **0 443 564 A2**

# (12) EUROPÄISCHE PATENTANMELDUNG

(21) Anmeldenummer: 91102505.4

(22) Anmeldetag: 21.02.91

(51) Int. Cl.5: **H01Q 17/00**, H01Q 15/00, H05K 9/00

(30) Priorität: 22.02.90 DE 4005676

(43) Veröffentlichungstag der Anmeldung:
28.08.91 Patentblatt 91/35

(84) Benannte Vertragsstaaten:
BE DE ES FR GB IT NL

(71) Anmelder: Buchtal Gesellschaft mit
beschränkter Haftung
Buchtalweg
W-8472 Schwarzenfeld(Opf.)(DE)

(72) Erfinder: **Bard, Marting**
**Seminargasse 26**
**W-8450 Amberg(DE)**
Erfinder: **Cremer, Gottfried, Dr.**
**Steyrer Weg 6**
**W-5022 Köln-Junkersdorf(DE)**

(74) Vertreter: **Herrmann-Trentepohl, Werner,**
**Dipl.-Ing. et al**
**Kirschner, Grosse, Bockhorni Forstenrieder**
**Allee 59**
**W-8000 München 71(DE)**

(54) Absorber für elektromagnetische Wellen.

(57) Eine Vorrichtung zur Absorption von elektromagnetischen Wellen, insbesondere Radarstrahlen, an Gebäuden, weist keramische Platten auf, die vorzugsweise an ihrer der Sichtseite abgewendeten Seite mit einer elektrischen Widerstandsbeschichtung mit einstellbarem Widerstand versehen sind und als im wesentlichen geschlossene Fassadenverkleidung mit einem eine destruktive Interferenz von elektromagnetischen Wellen, insbesondere Radarstrahlen, ermöglichenden Abstand von einer zwischen Gebäude und diesen Platten angebrachten, elektromagnetische Wellen vollständig reflektierenden Fläche angeordnet sind.

Fig. 1

Die Erfindung betrifft eine Vorrichtung in Art eines Absorbers für elektromagnetische Wellen gemäß dem Oberbegriff des Patentanspruches 1.

Im zivilen und militärischen Bereich zur Flugsicherung mit Hilfe des Radars werden elektromagnetische Wellen des Ultrakurzwellen-Bereiches zur Ortung und Kennung von Flugobjekten genutzt. Diese Radarortung im Bereich des sogenannten Sekundärradars als der Orientierung des Flugobjektes dienendes Mittel wird durch stärkere Bebauung und damit verbundene starke Reflektion von Radarwellen im Bereich der Flughäfen stark behindert und führt zu erheblichen Schwierigkeiten beim Einsatz dieses Flugsicherungssystems, weil es der Flugzeugbesatzung mit den vorhandenen technischen Hilfsmitteln im Flugzeug nicht mehr möglich ist, zwischen echten und unechten Radarinformationen zu unterscheiden. Es werden dabei von der Flugsicherung die Einhaltung bestimmter maximaler Reflektionswerte bei der Erstellung von Bauwerken respektive deren Fassaden auf Flughäfen oder nahe von Flughäfen gefordert, das heißt, diese Fassaden sollen ein eingeschränktes Reflektionsverhalten, das heißt, ein ausgeprägtes Dämpfungsverhalten zeigen.

Es zeigt sich jedoch, daß die bekannten Fassadenbaustoffe solche Eigenschaften nicht aufweisen, das heißt, diese Baustoffe reflektieren entweder selbst oder sind für die hinter der Fassade liegenden reflektierenden Bauteile eines Bauwerkes durchlässig (transparent).

Abhilfe versucht man mit Hilfe künstlich zusammengebauter Fassadenelemente zu schaffen, die als Absorber für elektromagnetische Wellen wirken und somit die Reflektion möglichst gering halten.

Diese Absorber arbeiten entweder nach dem sogenannten Prinzip des ständigen Übergangs, das heißt, als sogenannte Gradienten-Absorber oder nach dem Prinzip des auf Resonanzstrukturen aufbauenden Jaumann'schen Sumpfes. Beide Lösungsvorgaben für das vorgenannte Problem sind jedoch mit relativ komplizierten, in ihrer Wirkungsweise schwer vorhersehbaren Mehrschichtensystemen behaftet. Sie sind vergleichsweise teuer, kompliziert und witterungsempfindlich. Zudem sind diese Systeme brennbar und bieten keine architektonischen Gestaltungsmöglichkeiten.

Hier setzt die Erfindung ein und schlägt eine Vorrichtung zur Absorption von elektromagnetischen Wellen, insbesondere Radarstrahlen vor, die den Vorteil der Witterungsbeständigkeit, der Unbrennbarkeit mit einer vielseitigen architektonischen Gestaltungsmöglichkeit kombiniert und auf dem Prinzip der destruktiven Interferenz beruht und sich gemäß den Merkmalen der Patentansprüche auszeichnet.

Nachfolgend werden Ausführungsbeispiels der Erfindung anhand der Zeichnungen beschrieben.

Es zeigen:

Fig. 1    eine Schnittansicht einer Ausführungsform einer an einer Gebäudewand angeordneten Fassade und zwar nur eines Teils der Fassade, sowie

Fig. 2    eine Ansicht analog Fig. 1 von weiteren Ausführungsbeispielen.

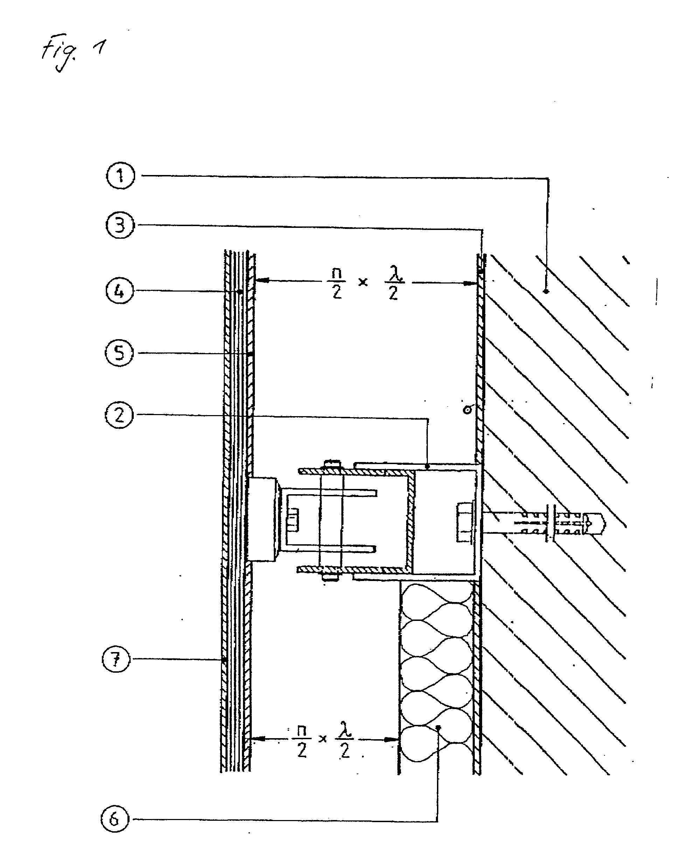

In Fig. 1 ist mit 1 eine Gebäudewand eines Gebäudes bezeichnet. An dieser Gebäudewand ist über ein konventionelles Halterungselement 2 die aufgehängte Fassade, bestehend aus der keramischen Platte 4, angeordnet. Das Halterungselement setzt sich gebäudeseitig aus einer U-Schiene zusammen, die über einen Dübel in der Gebäudewand befestigt ist. In dieser Schiene ist eine weitere Schiene 8 aufgenommen, an der über einen Gelenkbolzen ein an der Rückseite der keramischen Platte angeordnetes Halterungselement befestigt ist. Im übrigen kann hierfür auch jedes andere geeignete metallische Befestigungselement verwendet werden. Die Zeichnung zeigt lediglich ein Beispiel hiervon.

Die obere Hälfte der Darstellung in Fig. 1 zeigt eine Ausführungsform, bei der einen elektromagnetische Wellen vollständig reflektierende Fläche 3 unmittelbar an der Gebäudewand 1 befestigt ist, etwa durch Kleben. Hierfür eignet sich beispielsweise eine Metallfolie. In einem Abstand von $n/2 \times \lambda/2$ ist die keramische Platte 4 angeordnet, die an ihrer der Gebäudewand zugewandten Flächen mit einer elektrischen Widerstandsschicht 5 versehen ist. Die Sichtseite der keramischen Platte ist durch einen mit 7 bezeichnete elektrisch leitende Glasur gebildet.

In der unteren Hälfte der Darstellung nach Fig. 1 ist ein ähnliches Ausführungsbeispiel dargestellt, welches sich gegenüber der oberen Darstellung nur dadurch unterscheidet, daß an der Außenseite der reflektierenden Fläche 2 eine graphitierter Füll- oder Stützkörper befestigt ist. Hierfür eignet sich ein faseriges Material, insbesondere eine Mineralwollplatte, welche mit Graphitteilchen versetzt ist. Wesentlich ist, daß die Außenfläche des graphitierten Füll- oder Stützkörpers 6 mit der keramischen Platte 4 einen Abstand $n/2 \times \lambda/2$ bildet.

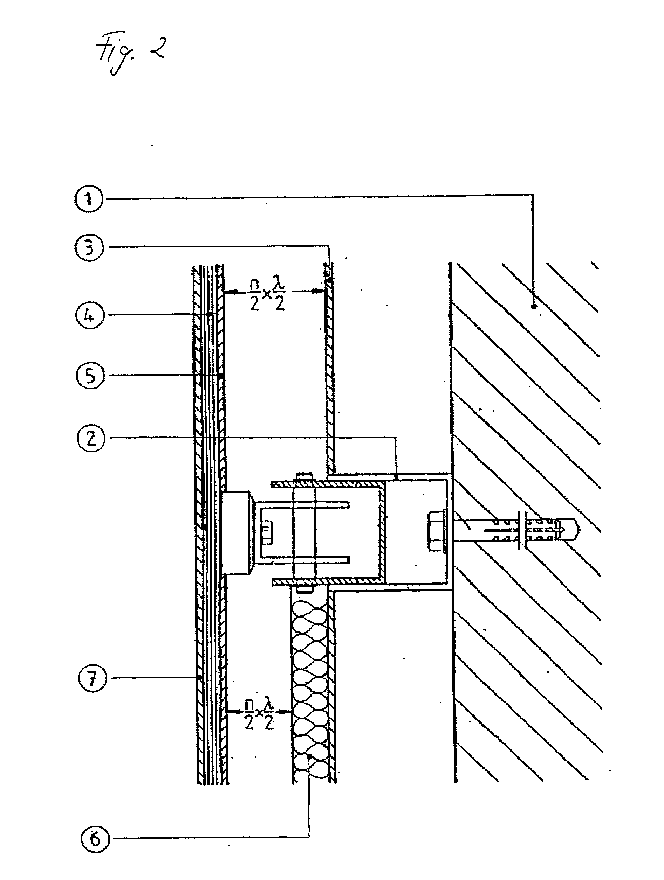

Bei der Ausführungsform nach Fig. 2 ist die vollständig reflektierende Fläche 3 mit Abstand vor der Gebäudewand 1 angeordnet, so daß zwischen der reflektierenden Fläche 3 und der Gebäudewand 1 gegebenenfalls auch eine Wärmeisolierung angebracht werden kann. Da die reflektierende Fläche 3 nicht vollflächig auf der Gebäudewand 1 anliegt, wie im Ausführungsbeispiel nach Fig. 1, ist in Fig. 2 die reflektierende Fläche 3 statisch stabiler ausgebildet, etwa durch eine dünne metallische Platte. Im übrigen ist der Abstand zwischen der reflektierenden Fläche 3 und der keramischen Platte 4 mit $n/2 \times \lambda/2$ berechnet.

In der unteren Hälfte der Fig. 2 ist analog zu Fig. 1 eine Ausführungsform dargestellt, bei der vor der reflektierenden Fläche 3 noch ein graphitierter Füll- oder Stützkörper 6 angeordnet ist.

Überraschend hat es sich gezeigt, daß mit den erfindungsgemäßen Maßnahmen eine hohe Dämpfung elektromagnetischer Wellen gewährleistet wird, das heißt, bei einer vorgegebenen Frequenz von 1,0 bis 1,1 Giga-Hertz nicht mehr als 20 Dezibel Reflektion oder ca. 1 % der rückstrahlenden Energie meßbar ist. Zugleich wird durch diese Maßnahmen für die keramische Fassadenverkleidung ein völlig neues Aufgabenfeld geschaffen. Für die angestrebte Schwächung der reflektierten Wellen gegebenenfalls sogar deren Auslöschung, das heißt, destruktive Interferenz, ist es notwendig, den Fassadenaufbau so zu gestalten, daß die einfallenden Radarwellen von der Fassadenoberfläche und der näher zum Baukörper hin angeordneten total reflektierenden Fläche so reflektiert werden, daß die beiden so entstandenen neuen Wellen gleiche Frequenz und gleiche Richtung aufweisen, das heißt, sich überlagern. Sie unterscheiden sich dann nur noch gegebenenfalls durch ihre Amplitude oder ihre Phase, das heißt, den Gangunterschied. Da das Ziel in der starken Schwächung bzw. Auslöschung besteht, ist dafür Sorge zu tragen, daß der Gangunterschied annähernd $\lambda/2 \times n$ beträgt, wobei n eine ungerade Zahl und $\lambda$ die Wellenlänge des Radarstrahles bzw. Radarwelle darstellt. Für den Bereich der Radarwellen, die hier mit einer Frequenz zwischen 1,0 bis 1,1 GHz arbeiten, kann von einer Wellenlänge, die etwa 30 cm beträgt ausgegangen werden. Der Abstand zwischen Fassadenoberfläche und vollständig reflektierender Fläche sollte demnach $n/2 \times \lambda/2$ betragen, wobei n eine ungerade Zahl ist.

**Patentansprüche**

1. Vorrichtung zur Absorption von elektromagnetischen Wellen, insbesondere Radarstrahlen, an Gebäuden, **dadurch gekennzeichnet**, daß die Vorrichtung keramische Platten aufweist, die vorzugsweise an ihrer der Sichtseite abgewendeten Seite mit einer elektrischen Widerstandsbeschichtung mit einstellbarem Widerstand versehen sind und als im wesentlichen geschlossene Fassadenverkleidung mit einem eine destruktive Interferenz von elektromagnetischen Wellen, insbesondere Radarstrahlen, ermöglichenden Abstand von einer zwischen Gebäude und diesen Platten angebrachten, elektromagnetische Wellen vollständig reflektierenden Fläche angeordnet sind.

2. Vorrichtung nach Anspruch 1, **dadurch gekennzeichnet**, daß die elektrische Widerstandsbeschichtung derart eingestellt ist, daß sie im Verbund mit der keramischen Platte eine Reflektion von ca. 50 % der Intensität der einfallenden elektromagnetischen Wellen ermöglicht, und auf den durchgehenden Anteil der Welle möglichst keinen die Frequenz ändernden Einfluß ausübt.

3. Vorrichtung nach Anspruch 1 oder 2, **dadurch gekennzeichnet**, daß sowohl die Sichtseite als auch die der Sichtseite abgewendete und mit einer elektrischen Widerstandsbeschichtung versehene Seite der keramischen Platte derart ausgebildet ist, daß kein die elektromagnetischen Eigenschaften verändernder Wassereintritt möglich ist.

4. Vorrichtung nach einem der Ansprüche 1 bis 3, **dadurch gekennzeichnet**, daß unter Berücksichtigung des vorherrschenden Einfallwinkels des Radarstrahles der Abstand zwischen den keramischen Platten und der vollständig reflektierenden Fläche annähernd $n/2 \times \lambda/2$ beträgt und n eine ungerade Zahl und $\lambda$ die Wellenlänge des Radarstrahles ist.

5. Vorrichtung nach einem der vorhergehenden Ansprüche, **dadurch gekennzeichnet**, daß die vollständig reflektierende Fläche aus einem gut elektrisch leitenden Material besteht und in einer festgelegten Ebene verläuft.

6. Vorrichtung nach einem der vorhergehenden Ansprüche, **dadurch gekennzeichnet**, daß auf der Sichtseite der keramischen Platte eine Glasur vorgesehen ist, die vorzugsweise elektrisch leitend ausgebildet ist, wobei der elektrische Widerstand sich vorzugsweise im niederohmigen Bereich befindet.

7. Vorrichtung nach einem der vorhergehenden Ansprüche, **dadurch gekenzeichnet**, daß die keramischen Platten großformatig sind, das heißt, eine Grundfläche $\geq 0,48$ m$^2$ und eine gleichbleibende Plattenstärke von 6 bis 10 mm, vorzugsweise 8 mm aufweisen.

8. Vorrichtung nach einem der vorhergehenden Ansprüche, **dadurch gekennzeichnet**, daß die keramischen Platten an ihrer der Sichtseite abgewendeten Seite nach statischen Gesichtspunkten angeordnete keramische Halterungselemente tragen, die mit Hilfe von metallischen Befestigungsmitteln an einer zum Gebäude gehörenden Unterkonstruktion befestigt sind.

9. Vorrichtung nach einem der vorhergehenden Ansprüche, **dadurch gekennzeichnet**, daß vor der vollständig reflektierenden Fläche ein graphitierter Füll- oder Stützkörper, insbesondere von fasriger Art, angeordnet ist, der in seiner Wandstärke und aufgrund seiner elektromagnetischen Eigenschaften derart bemessen ist, daß er einerseits zur Grunddämpfung des elektromagnetischen Strahls durch Umwandlung der elektromagnetischen Energie in Wärme beiträgt, und andererseits für den reflektierten Teil Interferenz zuläßt.

Fig. 1

$$\frac{n}{2} \times \frac{\lambda}{2}$$

$$\frac{n}{2} \times \frac{\lambda}{2}$$

Fig. 2

$$\frac{n}{2} \times \frac{\lambda}{2}$$

$$\frac{n}{2} \times \frac{\lambda}{2}$$